# EUROPÄISCHE PATENTSCHRIFT

(11) **EP 1 277 381 B1**
(45) Veröffentlichungstag und Bekanntmachung des Hinweises auf die Patenterteilung: **21.06.2006**
(21) Anmeldenummer: 01929311.7
(22) Anmeldetag: 03.04.2001
(51) Int. Cl.: H05K 13/04

(54) **ZUFÜHREINRICHTUNG FÜR IN GURTEN AUFGENOMMENE ELEKTRISCHE BAUTEILE**
FEEDING DEVICE FOR TAPED ELECTRIC COMPONENTS
DISPOSITIF D'ALIMENTATION POUR COMPOSANTS ELECTRIQUES PRIS EN CHARGE PAR DES BANDES

(30) Priorität: 27.04.2000 DE 10020749
(43) Veröffentlichungstag der Anmeldung: 22.01.2003
(73) Patentinhaber: Siemens AG, 80333 München (DE)
(72) Erfinder: LIEBEKE, Thomas, 85521 Ottobrunn (DE)
(86) Internationale Anmeldenummer: PCT/DE2001/001286
(87) Internationale Veröffentlichungsnummer: WO 2001/082660

(56) Entgegenhaltungen:
- EP-A- 0 589 275
- DE-A- 3 736 530

## Beschreibung

Die Erfindung bezieht sich auf eine Zuführeinrichtung für in mehreren Gurten aufgenommene elektrische Bauteile, wobei jeweils ein Gurt mittels eines Transportrades antreibbar ist, das über ein Übersetzungsgetriebe mit einem Elektromotor gekoppelt ist.

Durch die EP 0 589 275 A1 ist eine Zuführeinrichtung für gegurtete elektrische Bauteile bekannt geworden, bei der Transportstifte des Transportrades in Transportlöcher eines Gurtes eingreifen und diesen schrittweise derart antreiben, daß die in Taschen aufgenommenen Bauteile sukzessive in eine Abholposition gelangen, in der sie von einem Greifer eines Bestückautomaten für elektrische Leiterplatten entnommen werden können. Das Transportrad wird über ein Schneckengetriebe und ein Stirnradgetriebe von einem Antriebsmotor betätigt. Die Motorachse liegt auf der dem Gurt zugewandten Seite der Spindelachse des Schneckengetriebes. Da hier der Antriebsmotor mittels eines beweglichen Anschlags bei jedem Schritt eine volle Umdrehung bzw. ein ganzzahliges Vielfaches einer vollen Umdrehung benötigt, muß ein entsprechendes Übersetzungsverhältnis eingestellt werden, was durch das Stirnradgetriebe ermöglicht wird.

Durch die Siemens-Firmenschrift 0 299-S-23-500-d, Ausgabe 1, Seite 12, ist ferner eine Zuführeinrichtung bekannt geworden, in der zwei schmale Gurte in einer Zuführeinrichtung handhabbar sind. Dabei sind für die einzelne Gurte getrennte Antriebseinrichtungen gemäß der EP 589 275 A1 eingesetzt. Es ist üblich, die Dicke der Antriebsmotoren so gering zu halten, daß zwei der Motoren parallel nebeneinanderliegend innerhalb eines Gehäuses der Zuführeinrichtung Platz finden. Die Verdoppelung der Bauteilespuren hat den Vorteil der geringen Gesamtkosten mit nur einem Gehäuse, das aufgrund seiner größeren Breite besonders formstabil ausgebildet werden kann.

Auf den Seiten 2 und 3 der genannten Firmenschrift ist ein Bestückkonzept beschrieben und dargestellt, bei dem ein revolverartiger Bestückkopf mit einer Vielzahl von sternförmig abstehenden Greifern versehen ist. Wird eine Vielzahl von Bauteilen des gleichen Typs benötigt, so kann der Bestückkopf sehr schnell von Greifer zu Greifer weitergetaktet werden, ohne seine Position verändern zu müssen. Um die Bauteile entsprechend schnell nachziehen zu können, muß der Antriebsmotor der Zuführeinrichtung einen möglichst großen Durchmesser aufweisen, um die entsprechende Antriebsleistung erbringen zu können.

Der Erfindung liegt die Aufgabe zugrunde, die Dicke der Antriebsmotoren vergrößern zu können.

Diese Aufgabe wird durch die Erfindung gemäß Anspruch 1 gelöst. Durch den Versatz der Motorachsen können sich die Antriebsmotoren in der Achsrichtung der Transporträder seitlich überlappen, so daß die Motorendicke und damit die Leistung der Motoren erhöht werden kann. Insbesondere ist es möglich, die Gesamtdicke der Motoren auf ein Maß zu erhöhen, das größer ist als die Außenbreite der Zuführeinrichtung. Damit kann die Taktrate bei jedem der Gurte an eine erhöhte Taktrate des Revolverkopfes angepaßt werden, was sich in einer entsprechenden Leistungssteigerung des Bestückautomaten niederschlägt.

Vorteilhafte Weiterbildungen der Erfindung sind in den Unteransprüchen gekennzeichnet:

Durch das selbsthemmende Schneckengetriebe nach Anspruch 2 ist es möglich, die Motoren lediglich während der Antriebsphase eingeschaltet zu lassen und außerhalb dieser abzuschalten. Damit kann trotz der erhöhten Leistung die Wärmebelastung der Motoren und der Zuführeinrichtung auf ein unschädliches Niveau abgesenkt werden.

Durch die Weiterbildung nach Anspruch 3 ist es möglich, die Antriebsmotoren in ihrer geometrischen Anordnung in einfacher Weise zu entflechten.

Durch die Weiterbildung nach Anspruch 4 können die Motoren in einer einzigen Richtung orientiert bleiben, was den Einbau erleichtert. Durch ihre Parallelität bleibt das gesamte Hüllvolumen gering.

Durch die Weiterbildung nach Anspruch 5 kann die Anzahl der Motoren und damit die Anzahl der Antriebsräder und der Gurte bei gleichbleibenden Außenabmessungen erheblich erhöht werden. Dadurch ist es möglich, innerhalb der vorgegebenen Stellbreite der Zuführeinrichtungen die Anzahl der Spuren und damit die Anzahl der unterschiedlichen Bauteiletypen zu erhöhen.

Im folgenden wird die Erfindung anhand von in der Zeichnung schematisiert dargestellten Ausführungsbeispielen näher erläutert.
Figur 1 zeigt einen seitlichen Teilschnitt durch eine Zuführeinrichtung für gegurtete Bauteile,
Figur 2 einen Schnitt entlang der Linie II-II in Figur 1,
Figur 3 eine Draufsicht auf Funktionsteile nach Figur 1,
Figur 4 eine Seitenansicht von Antriebsteilen einer anderen Zuführeinrichtung ähnlich Figur 1.

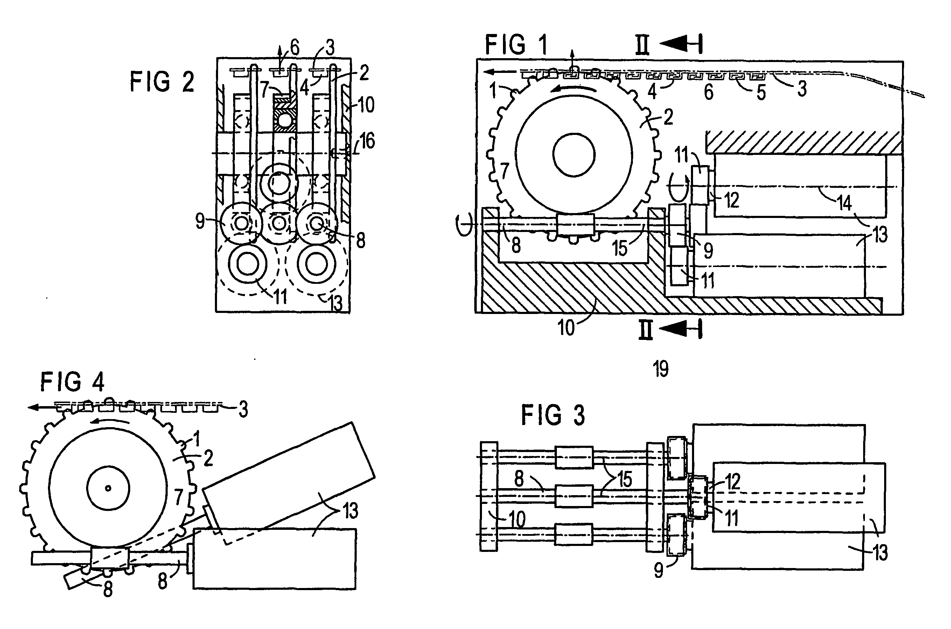

Nach den Figuren 1, 2 und 3 greifen zahnartige Transportstifte 1 eines Transportrades 2 in Transportlöcher eines Gurtes 3 ein, der mit Taschen 4 zur Aufnahme von elektrischen Bauteilen 5 versehen ist. Diese werden durch Verdrehen des Transportrades 2 um seine Drehachse 16 schrittweise in eine Abholposition transportiert, wo sie gemäß dem senkrechten Pfeil 6 von einem Greifer einer Bestückeinrichtung für elektrische Leiterplatten entnommen werden können.

Das Transportrad 2 wird durch ein Schneckengetriebe angetrieben, das aus einem mit dem Transportrad 2 verbundenen Schnekkenrad 7 und einer tangential angesetzten Spindel 8 gebildet ist, die an ihrem einen Ende ein Zahnrad 9 trägt. Die Spindel ist in einem Gehäuse 10 der Zuführeinrichtung parallel zur Transportrichtung des Gurtes 3 gelagert. Das Zahnrad 9 steht in Eingriff mit einem Antriebsritzel 11 einer Motorwelle 12 eines elektrischen Antriebsmotors 13. Dessen Motorachse 14 erstreckt sich parallel zur Spindelachse 15 der Antriebsspindel 8. Die beschriebenen Funktionsteile bilden eine Antriebseinheit für den Gurt 3.

Zusätzlich und parallel zu diesem sind noch zwei weitere der Gurte 3 vorgesehen, die in gleicher Weise durch zwei weitere, koaxial angeordnete Transporträder 2 angetrieben werden können. Diese werden von zwei weiteren Antriebsspindeln 8 verdreht, die sich senkrecht zur Achsrichtung der Transporträder 2 in einer Antriebsebene erstrecken, die senkrecht zur Drehebene der Transporträder 2 steht. Die Gesamtdicke der Antriebsmotoren ist größer als die Breite der Zuführeinrichtung in der Richtung der Drehachse 16. Sie sind jedoch, in der Drehebene der Transporträder betrachtet, zueinander derart versetzt, daß sich ihre Motorachsen 14 zu beiden Seiten der Antriebsebene befinden. In dieser Richtung ist ihr Abstand größer als ihre Dicke, so daß sie sich in der Draufsicht der Figur 3 gesehen gegenseitig überlappen können.

Der Durchmesser der Antriebsritzel 11 ist größer als der Teilungsabstand der Antriebsspindeln 8. Sie sind jedoch in deren Achsrichtung so weit zueinander versetzt, daß sie sich in ihrer Stirnansicht der Figur 2 gegenseitig überlappen können.

Bei der Zuführeinrichtung nach Figur 4 sind die Motorwellen 12 der Antriebsmotoren 13 unmittelbar mit den Antriebsspindeln 8 gekoppelt und erstrecken sich tangential zum Schnekkenrad 7 des Transportrades 2. Dabei ist der mittlere der Antriebsmotoren 13 mit der Antriebsspindel 8 so weit um die Drehachse der Transporträder 2 geschwenkt angeordnet, daß sich die Motorengehäuse außerhalb ihres Überlappungsbereiches befinden. Auf diese Weise können ebenfalls größere Motordikken innerhalb der Seitenbegrenzung der Zuführeinrichtung erzielt werden.

## Patentansprüche

1. Zuführeinrichtung für in mehreren Gurten (3) aufgenommene elektrische Bauteile (5),
wobei jeweils ein Gurt (3) mittels eines Transportrades (2) antreibbar ist, das über ein Übersetzungsgetriebe mit einem Antriebsmotor (13) gekoppelt ist,
wobei die Drehachsen (16) der Transporträder (2) koaxial angeordnet sind und
wobei die Motorachsen (14) der Antriebsmotoren (13) senkrecht zu den Drehachsen (16) gerichtet sind,
**dadurch gekennzeichnet,**
**daß** die Dicken der Antriebsmotoren (13) größer sind als die Teilungsabstände zwischen den Transporträdern (2) und
**daß** bei zumindest zwei der Antriebsmotoren (13) die Motorachsen (14) in einer Projektion senkrecht zur Drehebene der Transporträder (2) zueinander versetzt angeordnet sind.

2. Zuführeinrichtung nach Anspruch 1,
**dadurch gekennzeichnet,**
**daß** das Übersetzungsgetriebe als Schneckengetriebe ausgebildet ist,
**daß** ein Schneckenrad (7) des Schneckengetriebes fest mit dem Transportrad (2) verbunden ist und
**daß** eine tangential angesetzte Antriebsspindel (8) des Schneckengetriebes mit dem Antriebsmotor (13) gekoppelt ist.

3. Zuführeinrichtung nach Anspruch 2,
**dadurch gekennzeichnet,**
**daß** die Motorachsen (14) tangential zu den Schneckenrädern (7) orientiert sind und daß die Spindelachsen (14) und die Motorachsen (14) in der Drehrichtung der Transporträder (2) zueinander unterschiedliche Winkelstellungen aufweisen.

4. Zuführeinrichtung nach Anspruch 2,
**dadurch gekennzeichnet,**
**daß** die Spindelachsen (14) in einer zur Drehebene der Transporträder (2) senkrechten Ebene hintereinanderliegend angeordnet sind,
**daß** die Motorachsen (14) zueinander parallel gerichtet und in der Projektion senkrecht zur Drehebene der Transporträder (2) übereinanderliegend angeordnet sind und
**daß** Antriebswellen (12) der Antriebsmotoren (13) mit Antriebsritzeln (11) versehen sind, die in Zahnräder (9) der Antriebsspindeln (8) eingreifen und
**daß** die Antriebsritzel in abwechselnder Reihenfolge auf gegenüberliegenden Seiten der Zahnräder (9) angeordnet sind.

5. Zuführeinrichtung nach einem der vorhergehenden Ansprüche,
**dadurch gekennzeichnet,**
**daß** die Zuführeinrichtung drei zueinander parallele Transporträder (2) mit einer gemeinsamen Drehachse ((16) aufweist, daß die den beiden äußeren Transporträdern (2) zugeordneten Antriebsmotoren (13) in einer Höhe angeordnet sind
**daß** ihre Motorachsen (14) auf einer Seite der Zahnräder (9) verlaufen und
**daß** der dem mittleren Transportrad (2) zugeordnete Antriebsmotor (13) mit seiner Motorachse (14) auf der den anderen Motorachsen (14) gegenüberliegenden Seite der Zahnräder (9) angeordnet sind.

## Claims

1. Feeding device for electric components (5) held in a plurality of tapes (3),
it being possible in each case for a tape (3) to be driven by means of a transport wheel (2), which is coupled to a drive motor (13) via a step-up gear mechanism,
the axes of rotation (16) of the transport wheels (2) being arranged coaxially and
the motor axes (14) of the drive motors (13) being oriented at right angles to the axes of rotation (16),
**characterized**
**in that** the thicknesses of the drive motors (13) are greater than the pitch spacings between the transport wheels (2), and
**in that** in at least two of the drive motors (13), the motor axes (14) are arranged to be offset in relation to each other in a projection at right angles to the plane of rotation of the transport wheels (2).

2. Feeding device according to Claim 1, **characterized**
**in that** the step-up gear mechanism is constructed as a worm gear mechanism,
**in that** a worm wheel (7) of the worm gear mechanism is firmly connected to the transport wheel (2), and
**in that** a drive spindle (8) fitted tangentially and belonging to the worm gear mechanism is coupled to the drive motor (13).

3. Feeding device according to Claim 2, **characterized**
**in that** the motor axes (14) are oriented tangentially with respect to the worm wheels (7), and in that the spindle axes (14) and the motor axes (14) have different angular positions in relation to one another in the direction of rotation of the transport wheels (2).

4. Feeding device according to Claim 2, **characterized**
**in that** the spindle axes (14) are arranged one behind another in a plane at right angles to the plane of rotation of the transport wheels (2),
**in that** the motor axes (14) are oriented parallel to one another and are arranged one above another in the projection at right angles to the plane of rotation of the transport wheels (2), and
**in that** drive shafts (12) of the drive motors (13) are provided with drive pinions (11) which engage in gears (9) belonging to the drive spindles (8), and
**in that** the drive pinions are arranged in alternate sequence on opposite sides of the gears (9).

5. Feeding device according to one of the preceding claims,
**characterized**
**in that** the feeding device has three transport wheels (2) which are parallel to one another and have a common axis of rotation (16),
**in that** the drive motors (13) assigned to the two outer transport wheels (2) are arranged at one height,
**in that** their motor axes (14) run on one side of the gears (9), and
**in that** the drive motor (13) assigned to the central transport wheel (2) is arranged with its motor axis (14) on the side of the gears (9) opposite the other motor axes (14).

## Revendications

1. Dispositif d'alimentation pour des composants électriques (5) pris en charge dans plusieurs bandes (3),
une bande (3) étant respectivement entraînable au moyen d'une roue de transport (2) qui est couplée à un moteur d'entraînement (13) par l'intermédiaire d'un engrenage multiplicateur,
les axes de rotation (16) des roues de transport (2) étant disposés coaxialement et
les axes de moteur (14) des moteurs d'entraînement (13) étant orientés verticalement par rapport aux axes de rotation (16),
**caractérisé en ce**
**que** les épaisseurs des moteurs d'entraînement (13) sont supérieures aux écarts de pas entre les roues de transport (2) et
en ce que dans au moins deux des moteurs d'entraînement (13) les axes de moteur (14), dans une projection verticale par rapport aux roues de transport (2), sont disposés en étant décalés les uns par rapport aux autres.

2. Dispositif d'alimentation selon la revendication 1,
**caractérisé en ce**
**que** l'engrenage multiplicateur est conçu comme un engrenage à vis sans fin,
en ce qu'une roue à vis sans fin (7) de l'engrenage à vis sans fin est raccordée de manière fixe à la roue de transport (2) et
en ce qu'une broche d'entraînement (8) de l'engrenage à vis sans fin, appliquée de manière tangentielle, est couplée au moteur d'entraînement (13).

3. Dispositif d'alimentation selon la revendication 2,
**caractérisé en ce**
**que** les axes de moteur (14) sont orientés de manière tangentielle par rapport aux roues à vis sans fin (7) et en ce que les arbres de broche (14) et les axes de moteur (14) présentent des positions angulaires différentes les unes par rapport aux autres dans le sens de rotation des roues de transport (2).

4. Dispositif d'alimentation selon la revendication 2,
**caractérisé en ce**
**que** les axes de broche (14) sont disposés les uns derrière les autres dans un plan vertical par rapport au plan de rotation des roues de transport (2),
en ce que les axes de moteur (14) sont orientés parallèlement les uns aux autres et sont disposés les uns au-dessus des autres, en projection verticale au plan de rotation des roues de transport (2), et
en ce que les arbres d'entraînement (12) des moteurs d'entraînement (13) sont munis de pignons d'attaque (11) qui ont prise dans des roues dentées (9) des broches d'entraînement (8) et
en ce que les pignons d'attaque sont disposés en ordre alternant sur des côtés opposés des roues dentées (9).

5. Dispositif d'alimentation selon l'une quelconque des revendications précédentes,
**caractérisé en ce**
**que** le dispositif d'alimentation présente trois roues de transport (2) parallèles les unes aux autres, avec un axe de rotation (16) commun,
en ce que les moteurs d'entraînement (13) attribués aux deux roues de transport externes (2) sont disposés à une hauteur, en ce que leurs axes de moteur (14) s'étendent d'un côté des roues dentées (9) et
en ce que le moteur d'entraînement (13) attribué à la roue de transport centrale (2) est disposé avec son axe de moteur (14) sur le côté des roues dentées (9) opposé aux autres axes de moteur (14).
